# EUROPÄISCHE PATENTSCHRIFT

(11) **EP 2 003 566 B1**
(45) Veröffentlichungstag und Bekanntmachung des Hinweises auf die Patenterteilung: **27.04.2011**
(21) Anmeldenummer: 08104223.6
(22) Anmeldetag: 02.06.2008
(51) Int. Cl.: G06F 12/02, G11C 16/10, G11C 16/22

(54) **Verfahren und Steuergerät zum Betreiben eines nichtflüchtigen Speichers, insbesondere zum Einsatz in Kraftfahrzeugen**
Method and control device for operating a non-volatile memory, in particular for use in motor vehicles
Procédé et appareil de commande destinées au fonctionnement d'une mémoire non volatile en particulier à utiliser dans des véhicules automobiles

(30) Priorität: 08.06.2007 DE 102007026691
(43) Veröffentlichungstag der Anmeldung: 17.12.2008
(73) Patentinhaber: ROBERT BOSCH GMBH, 70442 Stuttgart (DE)
(72) Erfinder: Boettcher, Joern, 74232 Abstatt (DE); Liebehenschel, Jens, 65835 Liederbach (DE); Schmid, Markus, 70182 Stuttgart (DE)

(56) Entgegenhaltungen:
- EP-A- 1 729 305
- US-A- 4 578 751
- US-A- 4 811 294

## Beschreibung

### Technisches Gebiet

Die Erfindung betrifft ein Verfahren und ein Steuergerät zum Betreiben von nichtflüchtigen Speichern, insbesondere Flash- und EEPROM-Speichern, für den Einsatz z.B. im Automotiv-Bereich.

### Stand der Technik

Steuergeräte für den Automotiv-Bereich werden üblicherweise zur Steuerung und Überwachung von Funktionen des Fahrzeugmotors und/oder weiterer elektrischer Systeme im Kraftfahrzeug eingesetzt. Ein derartiges Steuergerät ist vorzugsweise mit einem nicht-flüchtigen Speicher ausgestattet, um verschiedene Betriebsgrößen und dgl. permanent, d.h. auch bei nicht anliegender Versorgungsspannung, zu speichern, sodass das Steuergerät z.B. auch auf zurückliegende Daten zurückgreifen kann.

Die Speicheradressen eines solchen nichtflüchtigen Speichers werden üblicherweise in Zeitabständen überschrieben, wobei nach einem Schreibvorgang auf den Adressbereich die betreffenden Speicherzellen normalerweise gelöscht werden müssen, bevor erneut Werte abgespeichert werden können. Ein mehrfaches Schreiben auf denselben Speicherbereich kann zu einer Beschädigung der betreffenden Speicherzellen und zu einer erheblichen Reduzierung der Lebensdauer des nicht-flüchtigen Speichers führen. Das Löschen eines derartigen nichtflüchtigen Speichers erfolgt beispielsweise durch einen Löschvorgang, wobei alle Speicherbits des nicht-flüchtigen Speichers bzw. eines adressierten Segments in geeigneter Weise in einen bestimmten Zustand, einen Gelöscht-Zustand, versetzt werden. Der Gelöscht-Zustand führt beim Auslesen des betreffenden Adressbereichs (ohne vorheriges Schreiben) zu einem bestimmten Datenmuster (im folgenden als Gelöscht-Daten oder als Gelöscht-Datenmuster bezeichnet), z.B. zur Ausgabe von logischen "1"en, so dass bei einem einfachen Auslesevorgang des Adressbereichs nicht erkennbar ist, ob der Adressbereich zuvor mit Daten eines entsprechenden Gelöscht-Musters beschrieben wurde oder noch nicht beschrieben wurde.

Nichtflüchtige Speicher, wie z.B. Flash-Speicher, für den Einsatz in Steuergeräten, insbesondere im Kraftfahrzeugbereich, werden in der Regel an aufeinander folgenden Adressen mit Daten beschrieben. Eine Adressinformation über eine Startadresse des zunächst zu beschreibenden Speicher kann dabei entweder durch einen entsprechenden Adresszähler in einer Steuereinheit oder durch entsprechende Verweisungsinformationen in einem weiteren Bereich des nichtflüchtigen Speichers festgehalten werden. Bei einem Fehlerfall, z.B. bei einem Ausfall der Stromversorgung an dem Steuergerät, kann der Inhalt des Adresszählers im Steuergerät verloren gehen. Erfolgt der Ausfall der Stromversorgung zwischen einem Schreiben der Daten in einen entsprechenden Speicherbereich des nichtflüchtigen Speichers und dem Schreiben der dazugehörigen Verweisungsinformation, so ist der Speicherbereich bereits beschrieben, jedoch noch keine Verweisungsinformation darüber gespeichert worden, dass in dem Speicherbereich Daten geschrieben worden sind. Bei einer erneuten Inbetriebnahme des Steuergeräts kann somit nur durch Analysieren des in dem nichtflüchtigen Speicher gespeicherten Inhalts festgestellt werden, ab welcher Adresse das Schreiben von Daten fortgesetzt werden kann. Kritisch ist insbesondere der Fall, bei dem zuletzt, d.h. vor dem Auftreten des Fehlers ein Datenmuster in einen entsprechenden Speicherbereich des nichtflüchtigen Speichers geschrieben worden ist, das dem Gelöscht-Muster des nicht-flüchtigen Speichers entspricht. Beim Auslesen eines solchen Speicherbereichs kann daher nicht erkannt werden, ob der betreffende Speicherbereich sich im Gelöscht-Zustand befindet oder vor dem Fehlerfall mit Daten beschrieben worden sind, die den Gelöscht-Daten entsprechen, und die aus dem entsprechenden Speicherbereich ausgelesen werden würden, wenn sich dieser im Gelöscht-Zustand befände.

Da jedoch ein Speicherbereich in einem nichtflüchtigen Speicher, wie er bei derartigen Steuergeräten verwendet wird, nur einmal beschreibbar ist, und anschließend zunächst ein Löschvorgang durchgeführt werden muss, bevor ein weiterer Schreibvorgang vorgenommen werden kann, muss folglich sichergestellt werden, dass auf einen einmal beschriebenen Speicherbereich nicht erneut geschrieben wird.

Die Druckschrift US 4,578,751 offenbart ein Verfahren zum gleichzeitigen Programmieren von mehreren nicht-flüchtigen Speichern, wobei ein Beschreiben eines Speicherplatzes in einem der nicht-flüchtigen Speicher, der im gelöschten Zustand nur Einsen enthält, nicht stattfindet, wenn die zu schreibenden Daten ebenfalls nur Einsen umfassen. Zum Überprüfen der geschriebenen Daten werden die Daten aus den Speicherplätzen ausgelesen und gegen die programmierten Daten überprüft. Wenn die in dem nicht-flüchtigen Speicher gespeicherten Daten nicht mit den geschriebenen Daten übereinstimmen, wird das Programmieren unterbrochen und eine Fehleranzeige generiert. Wird kein Fehler festgestellt, so wird das nächste zu programmierende Byte in den nicht-flüchtigen Speicher geschrieben.

### Offenbarung der Erfindung

Es ist daher Aufgabe der vorliegenden Erfindung, ein Verfahren und ein Steuergerät zum Betreiben eines nichtflüchtigen Speichers zur Verfügung zu stellen, bei denen sichergestellt wird, dass nicht bereits beschriebener Speicherbereich erneut beschrieben wird.

Diese Aufgabe wird durch das Verfahren nach Anspruch 1 sowie durch das Steuergerät gemäß dem nebengeordneten Anspruch gelöst.

Weitere vorteilhafte Ausgestaltungen der Erfindung sind in den abhängigen Ansprüchen angegeben.

### Kurzbeschreibung der Zeichnungen

Bevorzugte Ausführungsformen der vorliegenden Erfindung werden nachfolgend anhand der beigefügten Zeichnungen näher erläutert. Es zeigen:
- Fig. 1: eine Blockdarstellung eines Steuergeräts mit einer Steuereinheit gemäß einer Ausführungsform der Erfindung;
- Fig. 2: eine beispielhafte Darstellung von einem Speicherbereich des nichtflüchtigen Speichers zugeordneten Speicherzellen in einem Gelöscht-Zustand und in einem beschriebenen Zustand; und
- Fig. 3: ein Flussdiagramm zur Veranschaulichung des erfindungsgemäßen Verfahrens.

### Beschreibung der Ausführungsformen

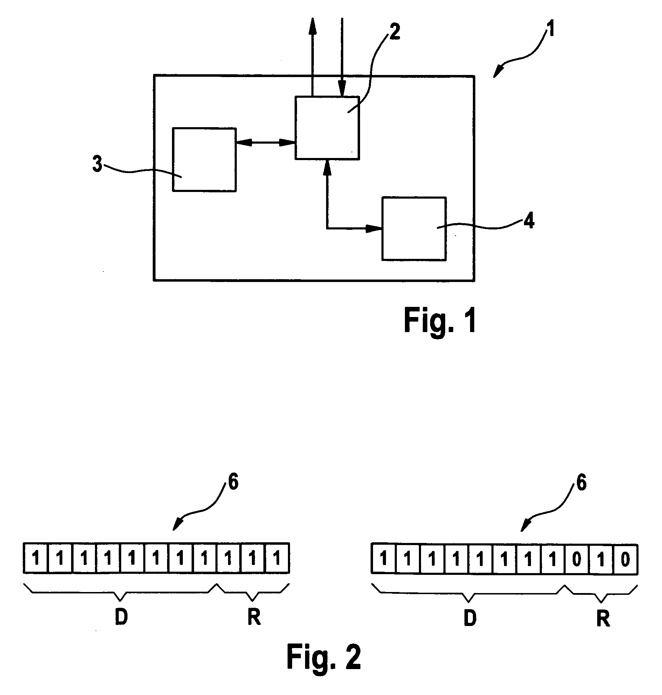

Fig. 1 zeigt ein Steuergerät 1 z.B. für den Einsatz im Automotiv-Bereich. Das Steuergerät 1 weist eine Steuereinheit 2 auf. Die Steuereinheit 2 führt Verfahren und Berechnungen durch, um eine Steuerung von Fahrzeugsystemen, wie z.B. die Motorsteuerung, die Steuerung weiterer elektrischer Systeme im Kraftfahrzeug und dgl. durchzuführen. Die Steuereinheit 2 ist mit einem Programm- und Festdatenspeicher 3 gekoppelt, indem Programmbefehle zum Durchführen des von der Steuereinheit 2 ausgeführten Steuerverfahrens sowie unveränderliche Festdaten, wie z.B. Konstanten, Kennfelder und dgl. gespeichert sind. Der Festdatenspeicher 3 ist vorzugsweise als nichtflüchtiger, durch die Steuereinheit 2 im Normalbetrieb nicht beschreibbarer Speicher, wie z.B. als ein ROM, Flash-Speicher, EPROM, EEPROM und dgl. ausgeführt.

Bei der Steuerung von Systemen durch die Steuereinheit 2 ist es häufig notwendig, Informationen über die zu steuernden Systeme, über Umfeldbedingungen und dgl. als Betriebsgrößendaten zu erfassen, zu ermitteln und zu aktualisieren, und die jeweils aktuellsten Betriebsgrößendaten permanent verfügbar zu halten, auch über einen Zeitraum hinweg, während dem das Steuergerät 1 für eine bestimmte Zeit ausgeschaltet ist, d.h. nicht mit einer Versorgungsspannung versorgt wird. Daten, die dann in einem etwaigen Arbeitsspeicher, wie z.B. einem flüchtigen Schreib-/Lesespeicher, z.B. einem RAM, gespeichert sind, gehen während einer solchen Zeitdauer verloren. Zum dauerhaften Speichern von Betriebsgrößendaten werden in der Regel ein nichtflüchtiger, durch die Steuereinheit 2 beschreibbarer Speicher 4, z.B. in Form eines Flash-Speichers und dgl. vorgesehen, auf den die Steuereinheit 2 zugreifen kann, um bestimmte Betriebsgrößen zu speichern bzw. auszulesen.

Um die Belastung des nichtflüchtigen Speichers 4 durch häufiges Beschreiben zu reduzieren, ist die Größe des nichtflüchtigen Speichers 4 größer vorgesehen als für die Speicherung der Betriebsgrößen benötigt. Jedoch ist dazu ein Speichermanagement erforderlich. Im Detail werden die zu speichernden Betriebsgrößendaten aufeinander folgend, d.h. der Reihe nach in den Adressbereich des nichtflüchtigen Speichers 4 (an aufsteigenden oder fallenden Adressen) geschrieben.

Das Beschreiben des nichtflüchtigen Speichers mit Betriebsgrößendaten erfolgt aufeinander folgend, d.h. neue zu schreibende Betriebsgrößendaten werden unmittelbar an das Ende der zuletzt geschriebenen Betriebsgrößendaten angehängt. Eine entsprechende Verweisungsoperation auf die zuletzt geschriebenen Betriebsgrößendaten kann entweder in einem Verweisungsbereich des nichtflüchtigen Speichers oder in dem Arbeitsspeicher des Steuergeräts, z.B. in einem Adresszähler oder dergleichen, gespeichert werden. Bei einem Fehlerfall, wie z.B. einem Ausfall der Stromversorgung, kann der Inhalt des Arbeitsspeichers verloren gehen. Auch kann nach einem Schreiben der Betriebsgrößendaten das Schreiben der zugehörigen Verweisungsinformation durch das Eintreten des Fehlerfalls unterbrochen werden, bzw. nicht erfolgen, so dass keine gültigen Verweisungsinformationen zu den geschriebenen Betriebsgrößendaten vorliegen.

In der Regel ist der Datenwert der zu schreibenden Betriebsgrößendaten nicht eingeschränkt, so dass es vorkommen kann, dass als Betriebsgrößendaten ein Datenmuster in einem Speicherbereich geschrieben wird, das dem Gelöscht-Datenmuster entspricht. Wie oben beschrieben, wird das Gelöscht-Datenmuster auch ausgegeben, wenn sich jedes Speicherbit des entsprechenden Speicherbereichs in einem Gelöscht-Zustand befindet. Somit lässt sich bei einer erneuten Inbetriebnahme des Steuergeräts 1 nach einem Fehlerfall anhand einer Analyse des nichtflüchtigen Speichers 4 nicht mehr feststellen, welcher Fall vorliegt. Bei der Analyse des nichtflüchtigen Speichers 4 nach einem Fehlerfall werden die Speicherbereiche des nicht-flüchtigen Speichers 4 nach einem entsprechenden Gelöscht-Muster durchsucht, das unmittelbar auf einen als mit Daten beschrieben erkannten Speicherbereich folgt. Der als mit Daten beschrieben erkannte Speicherbereich kann z.B. dadurch erkannt werden, dass die darin gespeicherten Daten nicht dem Gelöscht-Muster entsprechen oder dass entsprechende Verweisungsinformationen in dem nicht-flüchtigen Speicher gespeichert sind, die den beschriebenen Bereich angeben.

Wird ein Gelöscht-Muster in einem Speicherbereich erkannt, kann dies einerseits angeben, dass der entsprechende Speicherbereich noch nicht beschrieben worden ist und somit für ein nachfolgendes Beschreiben bereitsteht, oder dass der Speicherbereich andererseits mit Betriebsgrößendaten, die dem Gelöscht-Muster entsprechen, beschrieben worden ist und daher für ein nachfolgendes Beschreiben nicht bereitsteht.

In Fig. 2 ist anhand eines Beispiels dargestellt, weshalb ein bereits beschriebener Speicherbereich nicht mehr erneut beschrieben werden darf, wenn dieser bereits beschrieben wurde. Ein nicht-flüchtiger Speicher, insbesondere ein Flash-Speicher wie er in Automotiv-Anwendungen verwendet wird, weist Speicherbereiche 6 jeweils mit Datenbits D und Korrekturbits R auf. D.h. einem Speicherbereich 6, der, wie in diesem Beispiel gezeigt, 8 Bits Daten speichern kann, können physikalisch mehr als 8 Speicherzellen z.B. 11 Speicherzellen zugeordnet sein. Wenn ein solcher Speicherbereich 6 beschrieben wird, werden, wenn eine der Speicherzellen zum Speichern der Datenbits defekt ist, Korrekturbits gesetzt (siehe rechte Seite der Fig. 2). Diese Reparatur ist durch Auslesen nicht detektierbar. Aus der Speicherzelle sind die geschriebenen Daten korrekt auslesbar, obwohl eine der Speicherzellen zum Speichern der Datenbits defekt ist. Aufgrund eines eventuellen Beschreibens der Speicherzellen für die Korrekturbits wird der Speicherbereich für ein erneutes Beschreiben unbrauchbar, da sich einmal umprogrammierte Speicherzellen nicht erneut umprogrammieren lassen, ohne zuvor einen Löschvorgang durchgeführt zu haben.

Bei einem weiteren Typ von Flash-Speicher als nicht-flüchtigem Speicher befinden sich die Speicherzellen, d.h. deren Gate-Dielektrikum auf einem Potential, das einem Gelöscht-Zustand entspricht. Dieser Zustand wird beim Auslesen als ein bestimmter logischer Zustand interpretiert, z.B. als logische "1". Wird nun eine "1" in einem Schreibvorgang in die Speicherzelle geschrieben, so wird der Potentialzustand geändert, so dass ein weiteres Umprogrammieren der Speicherzelle auf eine logische "0" ohne vorhergehenden Löschprozess nicht mehr möglich ist, ohne die Speicherzelle zu beschädigen. Beim Auslesen des Speicherbereichs ergibt sich also das gleiche Datenmuster sowohl für einen nicht beschriebenen Speicherbereich als auch für den zuvor mit dem Gelöscht-Muster beschriebenen Speicherbereich, während im letzten Fall der Speicherbereich nicht mehr ohne vorangehenden Löschvorgang überschrieben werden darf.

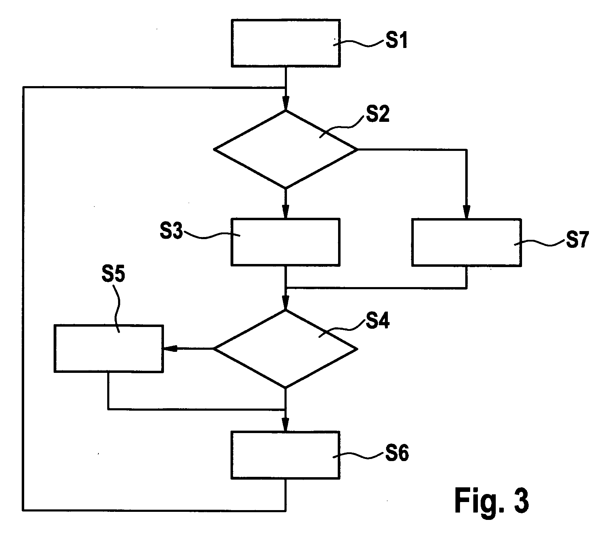

Erfindungsgemäß ist nun ein Verfahren zum Betreiben des nicht-flüchtigen Speichers 4 vorgesehen, wie es in dem Flussdiagramm der Fig. 3 dargestellt ist. Dabei werden in der Steuereinheit 2 zunächst die zu schreibenden Betriebsgrößendaten bereitgestellt (Schritt S1). In einem Schritt S2 wird überprüft, ob die Betriebsgrößendaten die ersten Daten sind, die nach dem Auftreten eines Fehlerfalls, wie z.B. eine Unterbrechung einer Stromversorgung des Steuergeräts, z.B. angezeigt durch einen Fehler-Marker oder dergleichen, geschrieben werden sollen. Ist dies nicht der Fall, wird das Verfahren mit Schritt S3 fortgesetzt, andernfalls mit Schritt S7. In dem Schritt S3 wird ein Speicherbereich in dem nicht-flüchtigen Speicher 4 festgelegt, in den die zu schreibenden Betriebsgrößendaten geschrieben werden sollen. Der Speicherbereich kann mit Hilfe eines Adresszählers in dem Steuergerät 2 oder mit Hilfe von in dem nicht-flüchtigen Speicher geschriebenen Verweisungsinformationen ermittelt werden und entspricht in der Regele dem Speicherbereich, der auf die zuletzt beschriebenen Speicherbereiche folgt. In einem nachfolgenden Schritt S4 analysiert die Steuereinheit 2 die zu schreibenden Betriebsgrößendaten. Wenn darin festgestellt wird, dass die Betriebsgrößendaten zu einem Schreiben eines Datenmusters auf den entsprechenden zu beschreibenden Speicherbereich im nicht-flüchtigen Speicher 4 führen würde, das nicht dem Gelöscht-Muster entspricht, beschreibt die Steuereinheit 2 den entsprechenden Speicherbereich mit den zu schreibenden Betriebsgrößendaten (Schritt S5). Wenn andererseits festgestellt wird, dass die Betriebsgrößendaten zu einem Schreiben eines Datenmusters auf den entsprechenden zu beschreibenden Speicherbereich im nichtflüchtigen Speicher 4 führen würde, das dem Gelöscht-Muster entspricht, beschreibt die Steuereinheit 2 den entsprechenden Speicherbereich nicht mit den Daten. Das Verfahren wird nach dieser Abfrage in beiden Fällen mit Schritt S6 fortgesetzt, in dem entweder, abhängig von der Speicherorganisation, der Adresszähler inkrementiert wird oder eine entsprechende Verweisungsinformation in den nichtflüchtigen Speicher 4 geschrieben wird, die auf den nicht beschriebenen Speicherbereich verweist.

Das Verfahren kehrt nun zu Schritt S2 zurück. Tritt kein Fehlerfall auf, so werden nachfolgende Betriebsgrößendaten in einen sich auf den entsprechenden Speicherbereich anschließenden Speicherbereich geschrieben. Somit wird der nichtflüchtige Speicher 4 zwar nicht in jedem Fall aufeinander folgend mit Betriebsgrößendaten beschrieben, jedoch werden nicht beschriebene Speicherbereiche als beschriebene Speicherbereiche interpretiert, wenn eine entsprechende Verweisungsinformation für den entsprechenden Speicherbereich vorhanden ist, oder wenn alternativ dem nicht beschriebenen Speicherbereich nachfolgend weitere beschriebene Speicherbereiche folgen.

Umgekehrt wird nach der Wiederaufnahme des Betriebs durch die Steuereinheit nach einem aufgetretenen Fehlerfall in Schritt S7 der nichtflüchtige Speicher 4 analysiert und der entsprechende Speicherbereich, aus dem ein Gelöscht-Muster ausgelesen werden kann, das auf einen bereits beschriebenen Speicherbereich folgt, als nicht beschriebener Speicherbereich angenommen. Dieser wird als Speicherbereich festgelegt, in das ein nachfolgend zu schreibendes Betriebsgrößendatum zu speichern ist. D.h. der entsprechende Speicherbereich kann, da er zuvor nicht beschrieben worden ist, nachfolgend für ein Beschreiben mit zu schreibenden Betriebsgrößendaten verwendet werden.

Durch das oben beschriebene Verfahren wird das Problem gelöst, dass nach einem Fehlerfall sichergestellt werden kann, dass nachfolgende Betriebsgrößendaten im Speicherbereich geschrieben werden können, aus denen Daten, die einem Gelöscht-Muster entsprechen, ausgelesen werden.

Das Gelöscht-Muster, das aus einem nicht beschriebenen Speicherbereich ausgelesen wird, ist im Wesentlichen vom Typ des nichtflüchtigen Speichers abhängig, und dessen Datenmuster ist im wesentlichen beliebig. Wesentlich ist, dass die Steuereinheit 2 die zu schreibenden Betriebsgrößendaten dahingehend überprüft, ob sie dem Gelöscht-Muster entsprechen. Ist dies der Fall, wird ein Schreiben unterdrückt und die auf die entsprechenden Speicherbereiche folgenden Speicherbereiche mit den nächsten Daten beschrieben.

Das Verfahren zum Betrieben eines nicht-flüchtigen Speichers wird vorzugsweise durch die Steuereinheit ausgeführt. Das Verfahren kann darin durch eine Hardware-Implementierung, einer Implementierung mit Hilfe einer Software, die einem Computerprogramm entspricht, sowie durch eine Implementierung durch Hardware und Software realisiert werden.

Ein Vorteil der Erfindung besteht darin, dass vermieden werden kann, dass bei der fehlerhaften Erkennung eines Zustands nach einem Fehlerfall bereits geschriebene Speicherzellen ohne vorheriges Löschen erneut beschrieben werden. Dies hätte zur Folge, dass die Lebensdauer der Speicherzelle deutlich reduziert wird oder nicht vorhersehbare Zustände in der Speicherzelle auftreten können.

## Patentansprüche

1. Verfahren zum Betreiben eines nicht-flüchtigen Speichers, wobei der nichtflüchtige Speicher (4) ausgebildet ist, dass bei einem Auslesen eines nicht beschriebenen Speicherbereichs ein Gelöscht-Datenmuster ausgelesen wird, mit folgenden Schritten:
- Festlegen (S3) eines Speicherbereichs zum Speichern von zu schreibenden Betriebsgrößendaten;
- Bereitstellen (S1) von in den nicht-flüchtigen Speicher zu schreibenden Betriebsgrößendaten;
- Überprüfen (S4), ob die zu schreibenden Betriebsgrößendaten dem Gelöscht-Datenmuster des festgelegten Speicherbereichs entsprechen;
- Schreiben (S5) der Betriebsgrößendaten in den bestimmten Speicherbereich, wenn die zu schreibenden Betriebsgrößendaten von dem Gelöscht-Datenmuster verschieden sind;
- wenn die zu schreibenden Betriebsgrößendaten dem Gelöscht-Datenmuster entsprechen, Verhindern eines Schreibens der Betriebsgrößendaten in den bestimmten Speicherbereich; **gekennzeichnet durch**:
- nach Eintreten eines Fehlerfalls, Analysieren der Speicherbereiche des nicht-flüchtigen Speichers (4), um die Speicherbereiche festzustellen, in denen das Gelöscht-Datenmuster gespeichert ist; und
- Bereitstellen (S7) mindestens eines der festgestellten Speicherbereiche für ein nachfolgenden Schreiben von zu schreibenden Betriebsgrößendaten.

2. Verfahren nach einem der Ansprüche 1, wobei nach dem Schreiben oder dem Verhindern eines Schreibens von Betriebsgrößendaten ein Adresszähler aktualisiert wird oder eine Verweisungsinformation in einen Verweisungsabschnitt des nicht-flüchtigen Speichers (4) geschrieben wird.

3. Steuergerät (1), insbesondere zum Einsatz in einem Kraftfahrzeug, umfassend:
- einen nicht-flüchtiger Speicher (4), der ausgebildet ist, um bei einem Auslesen eines nicht beschriebenen Speicherbereichs ein Gelöscht-Datenmuster auszulesen;
- eine Steuereinheit (2) , die ausgebildet ist,
- um einen Speicherbereich zum Speichern von zu schreibenden Betriebsgrößendaten zu bestimmen,
- um in den nicht-flüchtigen Speicher zu schreibende Betriebsgrößendaten bereitzustellen;
- um zu überprüfen, ob die zu schreibenden Betriebsgrößendaten dem Gelöscht-Datenmuster des bestimmten Speicherbereichs entsprechen;
- um die Betriebsgrößendaten in den bestimmten Speicherbereich zu schreiben, wenn die zu schreibenden Betriebsgrößendaten von dem Gelöscht-Datenmuster verschieden sind, oder wenn die zu schreibenden Betriebsgrößendaten dem Gelöscht-Datenmuster entsprechen, um ein Schreiben der Betriebsgrößendaten in den bestimmten Speicherbereich zu verhindern, **dadurch gekennzeichnet, dass**
die Steuereinheit (2) so ausgebildet ist, um nach Eintreten eines Fehlerfalls, die Speicherbereiche des nicht-flüchtigen Speichers (4) zu analysieren, um die Speicherbereiche festzustellen, in denen das Gelöscht-Datenmuster gespeichert ist; und um mindestens einen der festgestellten Speicherbereiche für ein nachfolgendes Schreiben von zu schreibenden Betriebsgrößendaten festzulegen.

4. Computerprogrammprodukt mit darauf gespeichertem maschinenlesbaren Code, mit dem eine Steuereinheit ansteuerbar ist, ein Verfahren gemäß einem der Ansprüche 1 bis 2 durchzuführen.

## Claims

1. Method for operating a non-volatile memory, the non-volatile memory (4) being designed in such a manner that a deleted data pattern is read when reading a memory area which has not been written to, said method having the following steps:
- a memory area for storing operating variable data to be written is determined (S3);
- operating variable data to be written to the non-volatile memory are provided (S1);
- a check is carried out (S4) in order to determine whether the operating variable data to be written correspond to the deleted data pattern from the memory area determined;
- the operating variable data are written (S5) to the memory area determined if the operating variable data to be written differ from the deleted data pattern;
- the operating variable data are prevented from being written to the memory area determined if the operating variable data to be written correspond to the deleted data pattern, **characterized in that**:
- the memory areas of the non-volatile memory (4) are analysed after the occurrence of a fault in order to determine the memory areas in which the deleted data pattern is stored; and
- at least one of the memory areas determined is provided (S7) for subsequent writing of operating variable data to be written.

2. Method according to Claim 1, in which an address counter is updated or an item of reference information is written to a reference section of the non-volatile memory (4) after operating variable data have been written or have been prevented from being written.

3. Control device (1), in particular for use in a motor vehicle, comprising:
- a non-volatile memory (4) which is designed to read a deleted data pattern when reading a memory area which has not been written to;
- a control unit (2) which is designed
- to determine a memory area for storing operating variable data to be written,
- to provide operating variable data to be written to the non-volatile memory,
- to check whether the operating variable data to be written correspond to the deleted data pattern from the memory area determined,
- to write the operating variable data to the memory area determined if the operating variable data to be written differ from the deleted data pattern or to prevent the operating variable data from being written to the memory area determined if the operating variable data to be written correspond to the deleted data pattern, **characterized in that**
the control unit (2) is designed to analyse the memory areas of the non-volatile memory (4) after the occurrence of a fault in order to determine the memory areas in which the deleted data pattern is stored, and to determine at least one of the determined memory areas for subsequent writing of operating variable data to be written.

4. Computer program product having machine-readable code stored thereon, which can be used to drive a control unit to carry out a method according to either of Claims 1 and 2.

## Revendications

1. Procédé de gestion d'une mémoire non volatile, la mémoire non volatile (4) étant configurée de telle sorte qu'un motif de données d'effacement est lu lors d'une lecture d'une zone de mémoire non occupée, le procédé comportant les étapes suivantes :
- définir (S3) une zone de mémoire destinée à conserver les données de grandeurs de fonctionnement à y écrire,
- préparer (S1) des données de grandeurs de fonctionnement à écrire dans la mémoire non volatile,
- vérifier (S4) si les données de grandeurs de fonctionnement à écrire correspondent au motif de données d'effacement de la zone de mémoire définie,
- si les données de grandeurs de fonctionnement à écrire sont différentes du motif de données d'effacement, écrire (S5) les données de grandeurs de fonctionnement dans la zone de mémoire définie,
- si les données de grandeurs de fonctionnement à écrire correspondent au motif de données d'effacement, empêcher l'écriture des données de grandeurs de fonctionnement dans la zone de mémoire définie, **caractérisé par** les étapes qui consistent à :
- après l'apparition d'une erreur, analyse des zones de mémoire de la mémoire non volatile (4) pour déterminer les zones de mémoire dans lesquelles le motif de données d'effacement est conservé et
- préparer (S7) au moins l'une des zones de mémoire définies pour la poursuite de l'écriture de données de grandeurs de fonctionnement à écrire.

2. Procédé selon la revendication 1, dans lequel après l'écriture ou l'empêchement de l'écriture de données de grandeurs de fonctionnement, un compteur d'adresses est mis à jour ou une information d'attribution est écrite dans une partie d'attribution de la mémoire non volatile (4).

3. Appareil de mémoire (1) destiné en particulier à être utilisé dans un véhicule automobile, et comprenant :
- une mémoire non volatile (4) configurée pour lire un motif de données d'effacement lors de la lecture d'une zone de mémoire non occupée,
- une unité de commande (2) configurée pour
- déterminer une zone de mémoire destinée à conserver des données de grandeurs de fonctionnement à y écrire,
- préparer les données de grandeurs de fonctionnement à écrire dans la mémoire non volatile,
- vérifier si les données de grandeurs de fonctionnement à écrire correspondent au motif de données d'effacement de la zone de mémoire définie,
- si les données de grandeurs de fonctionnement à écrire sont différentes du motif de données d'effacement, écrire les données de grandeurs de fonctionnement dans la zone de mémoire définie ou, si les données de grandeurs de fonctionnement correspondent au motif de données d'effacement, empêcher l'écriture des données de grandeurs de fonctionnement dans la zone de mémoire définie, **caractérisé en ce que**
l'unité de commande (2) est configurée pour, après l'apparition d'un défaut, analyser les zones de mémoire de la mémoire non volatile (4) pour découvrir les zones de mémoire dans lesquelles le motif de données d'effacement est conservé et pour définir au moins l'une des zones découvertes dans la mémoire pour la poursuite de l'écriture de données de grandeurs de fonctionnement à écrire.

4. Produit de programme informatique sur lequel est conservé un code lisible par machine et qui permet de piloter une unité de commande de telle sorte qu'elle exécute un procédé selon l'une des revendications 1 et 2.
